(19) Europäisches Patentamt
European Patent Office
Office européen des brevets

(11) **EP 3 778 657 A1**

(12) **EUROPEAN PATENT APPLICATION**
published in accordance with Art. 153(4) EPC

(43) Date of publication:
**17.02.2021 Bulletin 2021/07**

(21) Application number: **19776498.8**

(22) Date of filing: **26.03.2019**

(51) Int Cl.:
*C08F 2/44* (2006.01)   *B41M 5/00* (2006.01)
*C08F 2/48* (2006.01)   *C08K 3/013* (2018.01)
*C08L 101/00* (2006.01)   *C09D 11/322* (2014.01)
*H05K 3/28* (2006.01)

(86) International application number:
**PCT/JP2019/012874**

(87) International publication number:
**WO 2019/189190 (03.10.2019 Gazette 2019/40)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(30) Priority: **30.03.2018 JP 2018069385**
**30.03.2018 JP 2018069301**

(71) Applicant: **Taiyo Ink Mfg. Co., Ltd.**
**Hiki-gun, Saitama 355-0215 (JP)**

(72) Inventors:
• **YOSHIKAWA, Rina**
  **Hiki-gun, Saitama 355-0215 (JP)**
• **ITO, Hideyuki**
  **Hiki-gun, Saitama 355-0215 (JP)**
• **MATSUMOTO, Hiroshi**
  **Hiki-gun, Saitama 355-0215 (JP)**
• **WEI, Xiaozhu**
  **Hiki-gun, Saitama 355-0215 (JP)**
• **SHIMURA, Masayuki**
  **Hiki-gun, Saitama 355-0215 (JP)**

(74) Representative: **Hoffmann Eitle**
**Patent- und Rechtsanwälte PartmbB**
**Arabellastraße 30**
**81925 München (DE)**

(54) **CURABLE COMPOSITION, CURED PRODUCT OF SAME, AND ELECTRONIC COMPONENT COMPRISING SAID CURED PRODUCT**

(57)    [Problem to be Solved] Provided are a curable composition free from prior art shortcomings, having an excellent reflectance, yellowing properties, solder heat resistance, and crack resistance; a cured product of the curable composition and an electronic component having the cured product.

[Solution] A curable composition including (A) a white colorant, (B) a photopolymerization initiator, (C) a di- or higher functional (meth)acrylate monomer having a heterocycle, and (D) a thermosetting compound; a cured product thereof; and an electronic component having the cured product were obtained.

EP 3 778 657 A1

**Description**

Technical Field

The present invention relates to a curable composition and, in particular, a curable composition applicable to an inkjet printing method.
Moreover, the present invention relates to a cured product of the curable composition and an electronic component having the cured product.

Background Art

In recent years, liquid crystal displays are widely spread for the use in smartphones, personal computers, television, and the like, wherein light-emitting diodes (LEDs) are commonly used as backlights therefor. In addition to the above, LEDs are widely used as light sources for lighting apparatuses.
In printed wiring boards to be mounted for operating the LEDs, a solder resist, which is used as a permanent film provided on the surface of a printed wiring board, is white colored for reflection for effective utilization of the LED emission. Such method is used for enhancing the backlight effect in the liquid crystal displays or LED lightings. In other words, it is important for a white solder resist to provide a high reflectance, in addition to properties required to be a resist such as heat resistance and insulating property.
In order to obtain a white curable composition for the above, Patent Document 1, for example, proposed the use of a white colorant such as titanium oxide. Patent Document 2 also disclosed a fluorescent whitening agent added to a curable composition for improving the reflectance.
On the other hand, printed wiring boards have been manufactured by use of a photographic developing method and a screen printing method, for a coating step wherein a substrate of the printing board is coated with a composition for a solder resist. Those methods are used for protecting a conductor circuit on the substrate from solder adhesion, i.e., for applying the solder resist only to desired portions on the substrate. In the photographic developing method, patterning is performed by applying to a substrate, a photosensitive resin material with a photomask, followed by light exposure. Then, the portions of the photosensitive resin material which are not covered by the photomask are exclusively cured, while the uncured portions are dissolved with a developer. Thereafter, and then heat application or the like is carried out for further curing, to complete the patterning. This photographic developing method is a complex method involving a large number of steps such as application of a photosensitive resin material to the entire surface of a substrate, positioning of a photomask having a desired shape, light exposure, development, and thermal curing. As a result, cost including equipment investment and material is to be increased. In the screen printing method, a resist ink is applied to a screen (a stencil printing plate) having a preformed pattern. The resist ink is transferred to a substrate via the screen by the pressure application to the stencil printing plate with rubber plate called a squeegee. This method is also carried out with a relatively large number of steps, and the printing accuracy could not be evaluated satisfactory.
Following these existing technologies, a further printing technology has been developed, for applying a solder resist to a substrate using an inkjet printer (Patent Documents 3 and 4).
The inkjet method is an excellent method which enables highly precise image formation, eliminating complex procedures with a large number of steps required in the photographic developing method and the screen printing method. Moreover, the inkjet method is advantageous because of the significantly lowered investment on equipment, and the amount to be consumed of a developer, a resist ink, a cleaning solvent or the like can be minimized.
However, it is necessary for printing by use of an inkjet printer that the ink to be used has a predetermined flowability, irrespective of the type and color of a solder resist. Therefore, it is impossible to directly use existing inks designed for screen printing or the like, of which viscosity is about 20,000 mPa·s.
Accordingly, with various studies having been made, white curable compositions are proposed , which are applicable to inkjet printers, having excellent resist ink film forming property and dispersibility, as well as excellent coat film hardness and heat resistance (Patent Documents 5 and 6).

Prior Art Literature

Patent Documents

Patent Document 1: JP 2016-35042 A
Patent Document 2: WO 2016/157587
Patent Document 3: JP S56-66089 A

Patent Document 4: JP S56-157089 A
Patent Document 5: Japanese Patent No. 5968291
Patent Document 6 Japanese Patent No. 5667080

Summary of Invention

Problems to be solved by the Invention

It is so described in Patent Documents 5 and 6 that the cured coat films obtained from the white curable compositions give favorable results with respect to reflectance and yellowing suppression. However, the yellowing suppression is not necessarily satisfactory, and a further improvement would be possible in terms of solder heat resistance and crack resistance upon reflowing.
Accordingly, an object of the present invention is to provide a curable composition that does not have prior art drawbacks and that has excellent reflectance, yellowing suppression, solder heat resistance, and crack resistance.

Means for Solving the Problem

In order to achieve the above object, the curable composition of the present invention comprises (A) a white colorant, (B) a photopolymerization initiator, (C) a di- or higher functional (meth)acrylate monomer having a heterocycle, and (D) a thermosetting compound.
Moreover, (C) the di- or higher functional (meth)acrylate monomer having a heterocycle in the curable composition of the present invention is preferably a 5- or 6-membered alicyclic heterocycle compound having 1 or 2 heteroatoms.
Preferably, the curable composition of the present invention further comprises (E) a hyperbranched polymer or oligomer.
The white colorant (A) contained in the curable composition of the present invention preferably has an average particle diameter of 1 $\mu$m or less.
Preferably, the curable composition of the present invention further comprises (F) a fluorescent whitening agent and (G) a diluent for dissolving the fluorescent whitening agent.
Moreover, the curable composition of the present invention is preferably used with inkjet printing.
The cured product of the present invention is obtained by curing any of the above curable compositions, and the electronic component of the present invention comprises the cured product.

Effects of Invention

The curable composition of the present invention comprises (A) a white colorant, (B) a photopolymerization initiator, (C) a di- or higher functional (meth)acrylate monomer having a heterocycle, and (D) a thermosetting compound, and thus forms, after being cured, as a white cured product having an improved crack resistance upon reflowing and solder heat resistance as well as a high reflectance. Moreover, the cured coat film (the cured product) of the present invention shows well restricted yellowing even after a long period of time, maintaining the whiteness.
Moreover, the electronic component comprising the cured product of the present invention exhibits excellent light reflectance by the cured product, restricted yellowing , further having solder heat resistance and crack resistance upon reflowing.

Brief Description of Drawing

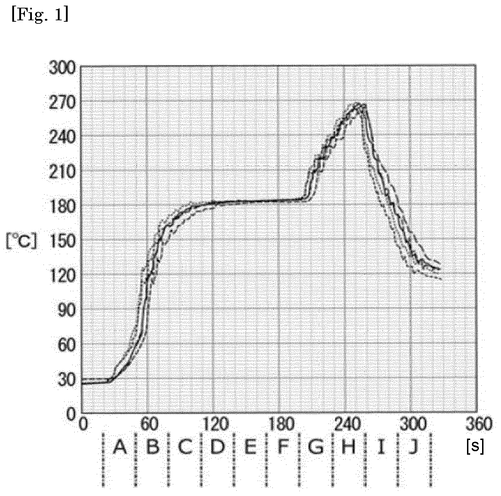

[Fig. 1] Fig. 1 is a graph showing the conditions of reflow treatment to be applied to the cured products (test substrates) from the curable compositions as embodiments of the present invention.

Mode for carrying out the Invention

The curable composition of the present invention comprises (A) a white colorant, (B) a photopolymerization initiator, (C) a di- or higher functional (meth)acrylate monomer having a heterocycle, and (D) a thermosetting compound. Having such formulation, the curable composition of the present invention exhibits not only excellent surface curability and coat film hardness, but also such a tendency not to have cracks during reflowing and good solder heat resistance.
In addition to the above components, (F) a fluorescent whitening agent and (G) a diluent for dissolving the fluorescent whitening agent are also used. Therefore, (F) the fluorescent whitening agent is well dissolved by (G) the diluent, and the resultant cured coating film (the cured product) has an improved reflectance as well as excellent insulating properties. The cured product of present invention preferably reflects light having a wavelength especially in the region of 400 to 500 nm and has an excellent reflectance for the light in this region.

The curable composition of the present invention forms a white coating film that has an improved reflectance and restricted yellowing with time. In other words, it is possible to suppress yellowing for a long period of time and maintain an excellent reflectance.

The curable composition of the present invention has a viscosity of 150 mPa·s or less at room temperature (25°C) and is suitable for use with inkjet printers.

Hereinafter, the components of the curable composition of the present invention will be described.

[(A) White colorant]

Examples of the white colorant (A) include titanium oxide, zinc oxide, potassium titanate, zirconium oxide, antimony oxide, white lead, zinc sulfide, and lead titanate. Titanium oxide is preferably used because of the large thermal discoloration restriction effect. By containing the white colorant (A), the composition of the present invention can be white colored, and a high reflectance can be obtained.

Titanium oxide may be titanium oxide having either one of rutile type, anatase type, and ramsdellite type, and one of these types may be used singly or two or more of these can be used in combination. Among these, ramsdellite type titanium oxide can be obtained by performing lithium desorption treatment on ramsdellite type $Li0.5TiO2$ by chemical oxidation.

Among the above, it is preferable to use rutile type titanium oxide, which will reduce discoloration tendency to be caused by light irradiation, and can prevent the product from the quality deterioration even in a severe application environment. A rutile type titanium oxide having a surface treated with aluminum oxide such as alumina or silica may be used.

Known rutile type titanium oxide can be used. There are two methods for producing rutile type titanium oxide, i.e., a sulfuric acid method and a chlorine method. In the present invention, rutile type titanium oxide produced by either one of the methods can be appropriately used.

Examples of the commercially available rutile type titanium oxide include Tipaque R-820, Tipaque R-830, Tipaque R-930, Tipaque R-550, Tipaque R-630, Tipaque R-680, Tipaque R-670, Tipaque R-680, Tipaque R-670, Tipaque R-780, Tipaque R-850, Tipaque CR-50, Tipaque CR-57, Tipaque CR-80, Tipaque CR-90, Tipaque CR-93, Tipaque CR-95, Tipaque CR-97, Tipaque CR-60, Tipaque CR-63, Tipaque CR-67, Tipaque CR-58, Tipaque CR-85, and Tipaque UT771 (all manufactured by ISHIHARA SANGYO KAISHA, LTD.); Ti-Pure R-100, Ti-Pure R-101, Ti-Pure R-102, Ti-Pure R-103, Ti-Pure R-104, Ti-Pure R-105, Ti-Pure R-108, Ti-Pure R-900, Ti-Pure R-902, Ti-Pure R-960, Ti-Pure R-706, and Ti-Pure R-931 (all manufactured by Du Pont); and R-25, R-21, R-32, R-7E, R-5N, R-61N, R-62N, R-42, R-45M, R-44, R-49S, GTR-100, GTR-300, D-918, TCR-29, TCR-52, FTR-700 (all manufactured by Sakai Chemical Industry Co., Ltd.).

Among the above, Tipaque CR-50, Tipaque CR-57, Tipaque CR-80, Tipaque CR-90, Tipaque CR-93, Tipaque CR-95, Tipaque CR-97, Tipaque CR-60, Tipaque CR-63, Tipaque CR-67, Tipaque CR-58, Tipaque CR-85, and Tipaque UT771 (manufactured by ISHIHARA SANGYO KAISHA, LTD.); and Ti-Pure R-100, Ti-Pure R-101, Ti-Pure R-102, Ti-Pure R-103, Ti-Pure R-104, Ti-Pure R-105, Ti-Pure R-108, Ti-Pure R-900, Ti-Pure R-902, Ti-Pure R-960, Ti-Pure R-706, and Ti-Pure R-931 (manufactured by Du Pont) produced by a chlorine method are preferably used.

Also, known anatase type titanium oxide is usable. Examples of usable commercially available anatase type titanium oxide include TITONE A-110, TITONE TCA-123E, TITONE A-190, TITONE A-197, TITONE SA-1, and TITONE SA-1L (manufactured by Sakai Chemical Industry Co., Ltd.); TA-100, TA-200, TA-300, TA-400, TA-500, and TP-2 (manufactured by Fuji Titanium Industry Co., Ltd.); TITANIX JA-1, TITANIX JA-3, TITANIX JA-4, TITANIX JA-5, TITANIX JA-C (manufactured by TAYCA CORPORATION); KA-10, KA-15, KA-20, and KA-30 (manufactured by Titan Kogyo, Ltd.); and Tipaque A-100, Tipaque A-220, and Tipaque W-10 (manufactured by ISHIHARA SANGYO KAISHA, LTD.).

The average particle diameter (the number average diameter (MN)) of the white colorant is preferably in the range of 1 μm or less, and particularly preferably in the range of 0.01 μm to 1 μm or less. When the particle diameter is 1 μm or less, the dispersibility of the pigment is improved, and the injection property of the curable composition is improved when used with an inkjet method. Further, the use of particles having particle diameter of 0.01 μm or more hardly brings about aggregation.

The average particle diameter as used herein is the average particle diameter (D50) obtained by including not only primary particles but also secondary particles (aggregates). The value of D50 is measured by a laser diffraction method. An exemplary measurement apparatus for the laser diffraction method is a Microtrac series manufactured by NIKKISO CO., LTD.

The amount of the white colorant blended is preferably in the range of 5 to 80% by mass and more preferably in the range of 10 to 50% by mass based on the total amount of the composition.

With the blending ratio of the white colorant being set to be 5% by mass or more, the film forming property of the curable composition improves, the warp deformation (curling) of the cured product hardly occurs, and the reflectance of the cured product is also improved. On the other hand, when the blending ratio of the white colorant is 80% by mass or less, the injection property in the inkjet printing is improved.

[(B) Photopolymerization initiator]

Any types of photopolymerization initiator (B) is applicable without particularly limitation, as long as the initiator can polymerize (meth)acrylate under the irradiation of an energy ray, making it possible to use a radical polymerization initiator.

As the photopolymerization initiator (B), any types of compound can be used, which produces a radical with irradiation of light, laser, electron beam or the like, to initiate a radical polymerization reaction. Examples of the radical photopolymerization initiator include benzoin/benzoin alkyl ethers such as benzoin, benzoin methyl ether, benzoin ethyl ether, and benzoin isopropyl ether; acetophenones such as acetophenone, 2,2-dimethoxy-2-phenylacetophenone, 2,2-diethoxy-2-phenylacetophenone, and 1,1-dichloroacetophenone; aminoacetophenones such as 2-methyl-1-[4-(methylthio)phenyl]-2-morpholinopropan-1-one, 2-benzyl-2-dimethylamino-1-(4-morpholinophenyl)-butan-1-one, and N,N-dimethylaminoacetophenone; anthraquinones such as 2-methylanthraquinone, 2-ethylanthraquinone, 2-t-butylanthraquinone, and 1-chloroanthraquinone; thioxanthones such as 2,4-dimethylthioxanthone, 2,4-diethylthioxanthone, 2-chlorothioxanthone, and 2,4-diisopropylthioxanthone; ketals such as acetophenone dimethyl ketal and benzyl dimethyl ketal; 2,4,5-triarylimidazole dimer; riboflavin tetrabutyrate; thiol compounds such as 2-mercaptobenzimidazole, 2-mercaptobenzoxazole, and 2-mercaptobenzothiazole; organohalogen compounds such as 2,2,2-tribromoethanol, and tribromomethyl phenyl sulfone; benzophenones such as benzophenone and 4,4'-bisdiethylaminobenzophenone, or xanthones; and acylphosphine oxides such as 2,4,6-trimethylbenzoyldiphenylphosphine oxide and bis(2,4,6-trimethylbenzoyl)-phenylphosphine oxide.

Examples of the commercially available photopolymerization initiators include Omnirad 907, Omnirad 127, Omnirad 81, Omnirad 819, Omnirad BDK, and Omnirad TPO (all manufactured by IGM Resins).

Each of the above radical photopolymerization initiators can be used singly, or a plurality of them can be used as a mixture. In addition to these, photoinitiator aids such as tertiary amines such as N,N-dimethylaminobenzoic acid ethyl ester, N,N-dimethylaminobenzoic acid isoamyl ester, pentyl-4-dimethylaminobenzoate, triethylamine, and triethanolamine can be used. Titanocene compounds and the like such as CGI-784 (manufactured by BASF Japan Ltd.) having absorption in the visible light region can also be added to a radical photopolymerization initiator for promoting an optical reaction. Components which may be added to the radical photopolymerization initiator are not limited to the above. A single one or multiple number of combined ones of the additives can be used, without being limited to the photopolymerization initiator and photoinitiator aids as long as the additive absorbs light in the ultraviolet light or visible light region and causes radical polymerization of an unsaturated group such as a (meth)acryloyl group.

It is preferable to use the photopolymerization initiator (B) in an amount of 0.1 to 50% by mass, and particularly in an amount of 1 to 40% by mass, based on the total amount of the curable composition. When the photopolymerization initiator (B) is blended in this range, photocurability on copper becomes satisfactory, and the curability and tack property of a coating film becomes excellent.

[(C) di- or higher functional (meth)acrylate monomer having a heterocycle]

The curable composition of the present invention contains a di- or higher functional (meth)acrylate monomer having a heterocycle (C) .

(Meth)acrylate as used herein is a collective term referring to acrylate, methacrylate, and a mixture of these, and the same also applies to other similar expressions.

In the present invention, the inclusion of the di- or higher functional (meth)acrylate monomer having a heterocycle (C) contributes to have a cured product of which high reflectance obtained from the white colorant (A) is maintained, with discoloration (yellowing) being restricted for a long period of time.

In particular, when titanium oxide is used as the white colorant (A) with a combined use of the di- or higher functional (meth)acrylate monomer having a heterocycle (C) , a cured coating film can be obtained which has a high reflectance, extremely good discoloration restriction effect, and an excellent reflectance which is to be maintained for a long period of time.

The di- or higher functional (meth)acrylate monomer having a heterocycle (C) use in the present invention may have at least one cyclic group selected from a group consisting of an alicyclic group and an aromatic group, each having one or two hetero atom(s).

Herein, it is preferable that the one or two (meth) acryloyl group (s) is/are structured to bond to two or more carbon atoms in the cyclic group directly or via a linear or branched lower alkylene group (such as methylene group, ethylene group, n-propylene group, i-propylene group, n-butylene group, or i-butylene group).

In the above cyclic group, the carbon(s) with or without a bond with the (meth)acryloyl group may be further substituted with a linear or branched lower alkyl group (such as methyl group, ethyl group, n-propyl group, i-propyl group, n-butyl group, or i-butyl group).

One or two heteroatoms contained in the heterocycle are any one or two in any combination of oxygen, nitrogen, and sulfur, and are preferably one or two oxygen atoms and in particular two oxygen atoms.

Examples of cyclic groups having a hetero atom include divalent groups of alicyclic groups such as azolidine, oxolane, thiolane, piperidine, tetrahydropyran, tetrahydrothiopyran, hexamethyleneimine, hexamethyleneoxide, hexamethylenesulfide, dioxane, and dioxolane; and aromatic groups such as azole, oxole, thiol, pyridine, pyridinium, azepine, oxepin, thiepine, imidazole, pyrazole, oxazole, thiazole, imidazoline, morpholine, pyridazine, pyrimidine, and pyrazine.

Among them, the di- or higher functional (meth)acrylate monomer having a heterocycle (C) in the present invention is preferably a 5- or 6-membered alicyclic heterocycle compound having 1 or 2 heteroatoms (particularly preferably oxygen). The heterocycle as a part of the monomer is preferably a 5- or 6-membered alicyclic heterocycle group such as tetrahydrofuran, tetrahydropyran, dioxane, or dioxolane, and, particularly preferably a difunctional acrylate having a dioxolane ring, such as 2-[5-ethyl-5-[(acryloyloxy)methyl]- 1,3-dioxan-2-yl]-2,2-dimethylethyl or 1,3-dioxane-5,5-dimethanol diacrylate.

The viscosity of the di- or higher functional (meth)acrylate monomer having a heterocycle (C) is preferably 500 mPa·s or less at room temperature (25°C) and in particular 200 to 400 mPa·s. Accordingly, the viscosity of the curable composition of the present invention is lowered as an effect.

KAYARAD R604 (manufactured by Nippon Kayaku Co., Ltd.) can be raised as an example of the commercially available product of the di- or higher functional (meth)acrylate monomer having a heterocycle (C).

The amount to blend the di- or higher functional (meth)acrylate monomer having a heterocycle (C) is preferably 1 to 60% by mass and in particular 4 to 40% by mass, based on the total mass of the curable composition of the present invention. By adding it in an amount of 1% by mass or more, the curability and hardness of the curable composition of the present invention is stably obtained. The addition in an amount of 60% by mass or less prevents the viscosity increase.

[(D) Thermosetting compound]

A thermosetting compound (D)can be added to the curable composition of the present invention. By adding the (D) thermosetting compound, adhesion and heat resistance are improved. As the thermosetting component (D) used in the present invention, known thermosetting compounds can be used, for example amino resins such as melamine resins, benzoguanamine resins, melamine derivatives, and benzoguanamine derivatives, block isocyanate compounds, cyclocarbonate compounds, thermosetting compounds having a cyclic (thio)ether group, bismaleimide, and carbodiimide resins. Having excellent storage stability, block isocyanate compounds are particularly preferable. One thermosetting compound (D) may be used, or two or more may be used in combination.

The above thermosetting compound having a cyclic (thio)ether group may be a compound having any one of 3-, 4-, or 5-membered cyclic (thio)ether groups within the molecule or two or more of those, for example, a compound having a plurality of epoxy groups within the molecule, i.e., a polyfunctional epoxy compound, a compound having a plurality of oxetanyl groups within the molecule or a polyfunctional oxetane compound, and a compound having a plurality of thioether groups within the molecule, e.g. an episulfide resin.

Examples of the polyfunctional epoxy compound, but are not limited to, include epoxidized vegetable oils such as Adeka Cizer O-130P, Adeka Cizer O-180A, Adeka Cizer D-32, and Adeka Cizer D-55 manufactured by ADEKA Corporation; bisphenol A epoxy resins such as jER 828, jER 834, jER 1001, and jER 1004 manufactured by Mitsubishi Chemical Corporation, EHPE3150 manufactured by Daicel Chemical Industries, Ltd., Epicron 840, Epicron 850, Epicron 1050, and Epicron 2055 manufactured by DIC Corporation, Epotohto YD-011, YD-013, YD-127, and YD-128 manufactured by Tohto Kasei Co., Ltd., D.E.R. 317, D.E.R. 331, D.E.R. 661, and D.E.R. 664 manufactured by Dow Chemical Company, Sumi-Epoxy ESA-011, ESA-014, ELA-115, and ELA-128 manufactured by Sumitomo Chemical Industry Company Limited, and A.E.R. 330, A.E.R. 331, A.E.R. 661, and A.E.R. 664 manufactured by Asahi Kasei Corporation (trade names); YDC-1312, hydroquinone epoxy resins, YSLV-80XY bisphenol F epoxy resin, and YSLV-120TE thioether epoxy resin (all manufactured by Tohto Kasei Co., Ltd.); brominated epoxy resins such as jER YL 903 manufactured by Mitsubishi Chemical Corporation, Epiclon 152 and Epiclon 165 manufactured by DIC Corporation, Epotohto YDB-400 and YDB-500 manufactured by Tohto Kasei Co., Ltd., D.E.R. 542 manufactured by Dow Chemical Company, Sumi-Epoxy ESB-400 and ESB-700 manufactured by Sumitomo Chemical Industry Company Limited, and A.E.R. 711 and A.E.R. 714 manufactured by Asahi Kasei Corporation (trade names); novolak epoxy resins such as jER 152 and jER 154 manufactured by Mitsubishi Chemical Corporation, D.E.N. 431 and D.E.N. 438 manufactured by Dow Chemical Company, Epiclon N-730, Epiclon N-770, and Epiclon N-865 manufactured by DIC Corporation, Epotohto YDCN-701 and YDCN-704 manufactured by Tohto Kasei Co., Ltd., EPPN-201, EOCN-1025, EOCN-1020, EOCN-104S, and RE-306 manufactured by Nippon Kayaku Co., Ltd., Sumi-Epoxy ESCN-195X and ESCN-220 manufactured by Sumitomo Chemical Industry Company Limited, and A.E.R. ECN-235 and ECN-299 manufactured by Asahi Kasei Corporation (trade names); biphenyl novolak epoxy resins such as NC-3000 and NC-3100 manufactured by Nippon Kayaku Co.,

Ltd.; bisphenol F epoxy resins such as Epiclon 830 manufactured by DIC Corporation, jER 807 manufactured by Mitsubishi Chemical Corporation, and Epotohto YDF-170, YDF-175, and YDF-2004 manufactured by Tohto Kasei Co., Ltd. (trade names); hydrogenated bisphenol A epoxy resins such as Epotohto ST-2004, ST-2007, and ST-3000 (trade names) manufactured by Tohto Kasei Co., Ltd.; glycidylamine epoxy resins such as jER 604 manufactured by Mitsubishi Chemical Corporation, Epotohto YH-434 manufactured by Tohto Kasei Co., Ltd., and Sumi-Epoxy ELM-120 manufactured by Sumitomo Chemical Industry Company Limited. (trade names); hydantoin epoxy resins; alicyclic epoxy resins such as Celloxide 2021 (trade name) manufactured by Daicel Chemical Industries, Ltd.; trihydroxyphenyl methane epoxy resins such as YL-933 manufactured by Mitsubishi Chemical Corporation, T.E.N., EPPN-501, and EPPN-502 manufactured by Dow Chemical Company (trade names); bixylenol epoxy resins, bisphenol epoxy resins, or mixtures of such bixylenol epoxy resin(s) and bisphenol epoxy resin(s) such as YL-6056, YX-4000, and YL-6121 (trade names) manufactured by Mitsubishi Chemical Corporation; bisphenol S epoxy resins such as EBPS-200 manufactured by Nippon Kayaku Co., Ltd., EPX-30 manufactured by ADEKA Corporation, and EXA-1514 manufactured by DIC Corporation (trade names); bisphenol A novolak epoxy resins such as jER 157S (trade name) manufactured by Mitsubishi Chemical Corporation; tetraphenylol ethane epoxy resins such as jER YL-931 (trade name) manufactured by Mitsubishi Chemical Corporation; heterocyclic epoxy resins such as TEPIC (trade name) manufactured by Nissan Chemical Industries, Ltd.; diglycidyl phthalate resins such as BLEMMER DGT manufactured by NOF CORPORATION; tetraglycidylxylenoylethane resins such as ZX-1063 manufactured by Tohto Kasei Co., Ltd.; naphthalene group-containing epoxy resins such as ESN-190 and ESN-360 manufactured by NIPPON STEEL Chemical and HP-4032, EXA-4750, and EXA-4700 manufactured by DIC Corporation; epoxy resins having a dicyclopentadiene skeleton such as HP-7200 and HP-7200H manufactured by DIC Corporation; glycidyl methacrylate copolymer-based epoxy resins such as CP-50S and CP-50M manufactured by NOF CORPORATION; copolymer epoxy resins from cyclohexyl maleimide and glycidyl methacrylate; and epoxy-modified polybutadiene rubber derivatives (such as PB-3600 manufactured by Daicel Chemical Industries, Ltd.) and CTBN-modified epoxy resins (such as YR-102 and YR-450 manufactured by Tohto Kasei Co., Ltd.). These epoxy resins can be used singly or in combinations of two or more. Of these, particular preference is given to novolac epoxy resins, bixylenol epoxy resins, biphenyl epoxy resins, biphenyl novolac epoxy resins, naphthalene epoxy resins, or mixtures thereof are preferable.

Examples of the polyfunctional oxetane compound include polyfunctional oxetanes such as bis[(3-methyl-3-oxetanylmethoxy)methyl] ether, bis[(3-ethyl-3-oxetanylmethoxy)methyl] ether, 1,4-bis[(3-methyl-3-oxetanylmethoxy)methyl]benzene, 1,4-bis[(3-ethyl-3-oxetanylmethoxy)methyl]benzene, (3-methyl-3-oxetanyl)methyl acrylate, (3-ethyl-3-oxetanyl)methyl acrylate, (3-methyl-3-oxetanyl)methyl methacrylate, (3-ethyl-3-oxetanyl)methyl acrylate, oligomers or copolymers from the above, and etherified of oxetane alcohol with a resin having a hydroxyl group such as a novolac resin, poly(p-hydroxystyrene), cardo bisphenol, calixarene, calixresorcinarene, or silsesquioxane. Further example is a copolymer of an unsaturated monomer having an oxetane ring and alkyl (meth)acrylate.

An example of the compound having a plurality of cyclic thioether groups within the molecule is bisphenol A episulfide resin YL7000 manufactured by Mitsubishi Chemical Corporation. An episulfide resin, in which the oxygen atom of the epoxy group of a novolac epoxy resin is replaced with a sulfur atom by using the same synthesis method, or the like can also be used.

Examples of amino resins such as melamine derivatives and benzoguanamine derivatives include methylol melamine compounds, methylol benzoguanamine compounds, methylol glycoluril compounds, and methylolurea compounds. Moreover, alkoxymethylated melamine compounds, alkoxymethylated benzoguanamine compounds, alkoxymethylated glycoluril compounds, and alkoxymethylated urea compounds can be obtained by converting the methylol groups of corresponding methylol melamine compounds, methylol benzoguanamine compounds, methylol glycoluril compounds, and methylolurea compounds, into alkoxymethyl groups, respectively. The kinds of the alkoxymethyl group are not particularly limited, and may be, for example, methoxymethyl group, ethoxymethyl group, propoxymethyl group, butoxymethyl group, or the like. In particular, a melamine derivatives having a formalin concentration of 0.2% or less, which are physically and environmentally friendly, are preferably used.

Examples of the commercially available products for the above include Cymel 300, Cymel 301, Cymel 303, Cymel 370, Cymel 325, Cymel 327, Cymel 701, Cymel 266, Cymel 267, Cymel 238, Cymel 1141, Cymel 272, Cymel 202, Cymel 1156, Cymel 1158, Cymel 1123, Cymel 1170, Cymel 1174, Cymel UFR65, Cymel 300 (manufactured by Mitsui Cyanamid Ltd.), and Nikalac Mx-750, Nikalac Mx-032, Nikalac Mx-270, Nikalac Mx-280, Nikalac Mx-290, Nikalac Mx-706, Nikalac Mx-708, Nikalac Mx-40, Nikalac Mx-31, Nikalac Ms-11, Nikalac Mw-30, Nikalac Mw-30HM, Nikalac Mw-390, Nikalac Mw-100LM, and Nikalac Mw-750LM (manufactured by SANWA Chemical Co., Ltd.). Such thermosetting compounds may be used singly or in combinations of two or more.

The isocyanate compound and the block isocyanate compound are compounds having a plurality of isocyanate groups or block isocyanate groups, respectively, within the molecule. Examples of such compounds having a plurality of isocyanate groups or block isocyanate groups within the molecule include polyisocyanate compounds and block polyisocyanate compounds. The block isocyanate group is a group obtained by reacting an isocyanate group with a blocking agent to protect and temporarily inactivate it, and when the block isocyanate group is heated to a specific temperature, the blocking agent dissociates, and an isocyanate group is produced. It was confirmed that curing property, and the rigidity of an obtained cured product, can be increased by adding the polyisocyanate compound or the block isocyanate compound,.

As the polyisocyanate compound, for example, aromatic polyisocyanate, aliphatic polyisocyanate, or alicyclic polyisocyanate may be used. Specific examples of the aromatic polyisocyanate include 4,4'-diphenylmethane diisocyanate, 2,4-tolylene diisocyanate, 2,6-tolylene diisocyanate, naphthalene-1,5-diisocyanate, o-xylylene diisocyanate, m-xylylene diisocyanate, and 2,4-tolylene dimer.

Specific examples of the aliphatic polyisocyanate include tetramethylene diisocyanate, hexamethylene diisocyanate, methylene diisocyanate, trimethylhexamethylene diisocyanate, 4,4-methylene bis (cyclohexyl isocyanate), and isophorone diisocyanate.

Specific examples of the alicyclic polyisocyanate include bicycloheptane triisocyanate. In addition, examples include adducts, burettes, and isocyanurates of the isocyanate compounds listed above.

As a block isocyanate compound, it is possible use a product of an addition reaction of an isocyanate compound with an isocyanate blocking agent. Examples of the isocyanate compound which can react with the blocking agent include the polyisocyanate compounds described above.

Examples of the isocyanate blocking agent include phenol-based blocking agents such as phenol, cresol, xylenol, chlorophenol, and ethylphenol; lactam-based blocking agents such as $\varepsilon$-caprolactam, $\delta$-valerolactam, $\gamma$-butyrolactam, and $\beta$-propiolactam; active methylene-based blocking agents such as ethyl acetoacetate and acetylacetone; alcohol-based blocking agents such as methanol, ethanol, propanol, butanol, amyl alcohol, ethylene glycol monomethyl ether, ethylene glycol monoethyl ether, ethylene glycol monobutyl ether, diethylene glycol monomethyl ether, propylene glycol monomethyl ether, benzyl ether, methyl glycolate, butyl glycolate, diacetone alcohol, methyl lactate, and ethyl lactate; oxime-based blocking agents such as formaldehyde oxime, acetaldoxime, acetoxime, methyl ethyl ketoxime, diacetyl monooxime, and cyclohexane oxime; mercaptan-based blocking agents such as butyl mercaptan, hexyl mercaptan, t-butyl mercaptan, thiophenol, methylthiophenol, and ethylthiophenol; acid amide-based blocking agents such as acetic acid amide and benzamide; imide-based blocking agents such as succinimide and maleic imide; amine-based blocking agents such as xylidine, aniline, butylamine, and dibutylamine; imidazole-based blocking agents such as imidazole and 2-ethylimidazole; imine-based blocking agents such as methyleneimine and propyleneimine.

Examples of the commercially available product of block isocyanates include BI7982 and BI7992 (all manufactured by Baxenden Chemicals Ltd.).

The amount to blend the thermosetting compound blended is preferably 1 to 30% by mass based on the total amount of the composition. When the amount is 1% by mass or more, sufficient rigidity and heat resistance of a coating film are obtained. On the other hand, when the amount is 30% by mass or less, which is considered to be sufficient rate to have the performance as a photocurable compound(s), the optical and thermal curing/setting properties can be attained.

The curable composition of the present invention, which comprises the thermosetting compound (D) or block isocyanate will impart improved strength to the resultant coat film and improved solder heat resistance thereof, as well as remarkably high crack resistance during reflowing.

[(E) Hyperbranched polymer or oligomer having ethylenically unsaturated group]

The curable composition of the present invention preferably contains a hyperbranched polymer or a hyperbranched polymer having an ethylenically unsaturated group (E) (also referred to as a "hyperbranched compound").

The curable composition of the present invention may further contain a hyperbranched oligomer or a hyperbranched polymer. In the present invention, the hyperbranched oligomer or polymer having an ethylenically unsaturated group is a compound in which the hyperbranched oligomer or polymer (which refers to an oligomer or polymer having a plurality of branched chains within one molecule) skeleton has at least one ethylenically unsaturated group. The ethylenically unsaturated group can be derived from a functional group such as a (meth)acryloyl group, or the like and may have a plurality of ethylenically unsaturated groups within the molecule. The (meth)acryloyl group is a concept encompassing both an acryloyl group and a methacryloyl group.

The hyperbranched oligomer and/or polymer having an ethylenically unsaturated group (hereinafter also simply referred to as a "hyperbranched oligomer or polymer") is preferably a compound having a dendrimer structure (a dendritic structure) (hereinafter also simply referred to as a dendrimer), a compound having a hyperbranched structure (hereinafter also simply referred to as a hyperbranch (oligomer, polymer)), a compound (oligomer, polymer) having a star structure, and a compound (oligomer, polymer) having a graft structure, wherein the compound has a functional group having an ethylenically unsaturated bond, such as a (meth)acryloyl group.

The dendrimer in the present invention is a generic nomination referring to compounds having a structure in which branched chains are radially extended. The specific kind of the dendrimer is not particularly limited, and one or more can be selected from known dendrimers such as amidoamine-based dendrimers, phenyl ether-based dendrimers, and hyperbranched polyethylene glycols.

The hyperbranched oligomer or polymer generally has a weight average molecular weight (Mw) of 1000 to 20000 and preferably 1000 to 8000. The weight average molecular weight (Mw) herein has been measured through a molecular weight distribution curve based on gel permeation chromatography measurement, under the conversion by use of polystyrene.

The number of the functional group, in particular (meth)acryloyl group, corresponding to the ethylenically unsaturated group in the molecule of the hyperbranched compound (E) for use in the present invention can be selected not to impair a desired effect of the invention. The number of the functional group is preferably 3 or more and, in particular, in the range of 4 to 30. In a photocurable composition, in particular, for use in inkjet can include a hyperbranched oligomer or polymer having 30 or less of functional groups in number, to have a viscosity of 150 mPa·s or less at room temperature (25°C).

The method for producing the dendrimer is not particularly limited, and a known production method can be employed. Examples of the production methods are a divergent method wherein molecules are bonded to a central core molecule in the sequence of respective generations to form branches; a convergent method wherein a branch moieties synthesized in advance are bonded to a core molecule; and a method of a one-step synthesis performed using a monomer ABx having in the molecule a branched moiety with two or more reaction points B and a link moiety with further reaction point A.

Commercially available dendrimers are usable, and examples include Etercure 6361-100 (manufactured by Eternal Materials Co., Ltd.), Doublermer (DM) 2015 (manufactured by Double Bond Chemical Ind. Co., Ltd.), SP1106 (manufactured by Miwon Specialty Chemical Co., Ltd.), and Viscoat #1000 (manufactured by Osaka Organic Chemical Industry Ltd.).

In addition, dendrimers are available from Iris Biotech GmbH, Kanto Chemical Co., Inc., Merk Millipore S.A.S, QIAGEN N.V., Sigma-Aldrich Co. LLC., Techno Chemical Corp., Double Bond Chemical Ind. Co., Ltd., Osaka Organic Chemical Industry Ltd., Hakuto Co., Ltd., or the like.

In the present invention, the use of a hyperbranched oligomer or polymer having an ethylenically unsaturated group (E) improves the adhesion between the curable composition and a substrate. Moreover, the cured product will have an improved hardness. Also, plating resistance, even under severe plating treatment conditions, can be increased.

Since the hyperbranched oligomer or polymer having an ethylenically unsaturated group (E) provides a relatively low viscosity even when the number of functional groups or the amount of the oligomer or polymer used is increased, the oligomer or polymer has a significance in order to impart improved hardness to the curable composition.

The amount to blend the hyperbranched oligomer or polymer having an ethylenically unsaturated group (E) is preferably 0.1 to 40% by mass, based on the total mass of the curable composition. With the amount of 0.1 or more, the hardness of a coat film is increased, and with the amount being 40% by mass or less, a viscosity increase of the curable composition can be restricted.

[(F) Fluorescent whitening agent]

The curable composition of the present invention can also have a formulation including a fluorescent whitening agent (F). The fluorescent whitening agent (F) is a material for absorbing ultraviolet rays and convert them into bluish white light (fluorescence) in the visible light region. Therefore, the fluorescent whitening agent increases reflectance and thus functions to amplify the whiteness of the cured product of the curable composition, when added to the curable composition of the present invention containing the white colorant (A).

Examples of such fluorescent dye include benzoxazole derivatives, coumarin derivatives, styrene biphenyl derivatives, pyrazolone derivatives, and bis(triazinylamino)stilbene disulfonic acid derivatives. In particular, benzoxazole derivatives are preferably used.

The amount of the fluorescent whitening agent (F) to be blended in the composition of the present invention can be 0.01 to 3% by mass and preferably 0.1 to 1% by mass based on the following diluent (G) that dissolves the fluorescent whitening agent. When the amount is in the above range, the fluorescent whitening agent is well dissolved in the diluent, and excellent insulating property and reflectance are obtained.

[(G) Diluent for dissolving fluorescent whitening agent]

When the above fluorescent whitening agent (F) is contained, a diluent for dissolving the fluorescent whitening agent can also be contained in the curable composition.

As the diluent (G) of the present invention for dissolving the fluorescent whitening agent, a reactive diluent, a non-reactive organic solvent, or both are used. In the present invention, "the diluent (G) for dissolving the fluorescent whitening agent" refers to a diluent that forms a state in which fluorescent whitening agent particles cannot be visually recognized at all when 0.5% by mass of the fluorescent whitening agent (F) is added to the amount of the diluent (G) for dissolving the fluorescent whitening agent (F) and is then stirred for 30 minutes at a diluent temperature of 40°C.

In the present invention, it has been made clear that the insulating properties are affected when undissolved residue of the fluorescent whitening agent remains in the curable composition. Therefore, the excellent insulating property of the curable composition of the present invention can be ensured by the use of the diluent (G) for dissolving the fluorescent whitening agent.

In the present invention, it is possible to use the diluent (G) for dissolving the fluorescent whitening agent having a solubility parameter (the Sp value) of 9.4 or less.

Examples of the diluent (G) for dissolving the fluorescent whitening agent include linear or branched alkyl (meth)acrylates such as n-butyl acrylate, isooctyl acrylate, isodecyl acrylate, lauryl acrylate, and isostearyl acrylate; alkylene di(meth)acrylates such as 1,9-nonanediol diacrylate and 1,6-hexanediol diacrylate; mono(meth)acrylates of alkylene glycols such as ethylene glycol, methoxytetraethylene glycol, polyethylene glycol, propylene glycol, and diethylene glycol; dialkylene glycol di(meth)acrylates such as diethylene glycol diacrylate and dipropylene glycol diacrylate; and acrylates having a cyclic group, such as (2-methyl-2-ethyl-1,3-dioxolan-4-yl)methyl acrylate and isobornyl acrylate.

It is possible to use vinyl ether such as diethylene glycol divinyl ether for some cases. However, the above-described radically polymerizable acrylates are preferably used from the viewpoint of reaction rate and curability.

Moreover, as long as the fluorescent whitening agent (F) is dissolved, methacrylates corresponding to the above acrylates can also be used.

Among them, alkyl acrylates or alkylene diacrylates, in particular, alkylene diacrylates such as 1,6-hexanediol diacrylate and 1,9-nonanediol diacrylate are preferably used.

As an organic solvent which can be used as the diluent (G) for dissolving the fluorescent whitening agent, any organic solvent may be used, without restrictions, as long as it works as a diluent for dissolving the fluorescent whitening agent.

Known and commonly used organic solvents can be used, e.g., ketones such as methyl isopropyl ketone, methyl propyl ketone, and methyl ethyl ketone; glycol ethers such as dipropylene glycol dimethyl ether, dipropylene glycol methyl-n-propyl ether, and dipropylene glycol methyl ether acetate, acetic acid esters such as ethyl acetate, butyl acetate, isopropyl acetate, isobutyl acetate, dipropylene glycol diacetate, dipropylene glycol methyl ether acetate, propylene glycol monomethyl ether acetate, and dipropylene glycol monomethyl ether acetate, alicyclic group-containing acetic acid esters such as cyclohexanol acetate, and aliphatic hydrocarbons such as n-pentane, n-hexane, diethyl ether, octane, and n-decane. These organic solvents may be used singly or in combinations of two or more.

The diluent (G) for dissolving the fluorescent whitening agent in the curable composition of the present invention preferably contains a diacrylate having an alkylene skeleton or alkyl acrylate, and, in particular, a diacrylate having an alkylene skeleton. The amount of the diluent (G) for dissolving the fluorescent whitening agent is preferably in the range of 40 to 70% by mass and, in particular, in the range of 50 to 65% by mass, based on the total mass of the curable composition.

In the present invention, it is preferable to use only a reactive diluent(s) as the diluent (G) for dissolving the fluorescent whitening agent. By such use, the diluent(s) would not evaporate even when continuous printing is performed for a long period of time. Thus, there is such an advantage that printing can be performed with the viscosity being maintained stably.

When the amount of the diluent (G) for dissolving the fluorescent whitening agent is 40% by mass or more, it is possible to prevent the film from having the thickness decreased at the curing of the curable composition of the present invention. When the amount is 70% by mass or less, the heat resistance of the resultant cured product can be satisfactory

[Other components]

[Photocurable compound]

The curable composition of the present invention may contain, in addition to the above-described di- or higher functional (meth)acrylate monomer having a heterocycle (C) and the hyperbranched polymer or oligomer (E) having a (meth)acryloyl group, a photocurable compound different therefrom.

A compound having one or more (meth)acryloyl groups within the molecule can be used as the photocurable compound.

Examples of the commercially available (meth)acrylate compounds, which can be used as the photocurable compounds in the present invention, include Neomer DA-600 (manufactured by Sanyo Chemical Industries, Ltd.), Aronix M-309, M-7100, and M-309 (manufactured by TOAGOSEI CO., LTD.), A-DCP (manufactured by SHIN-NAKAMURA CHEMICAL Co., Ltd.), 1.6HX-A (manufactured by Kyoeisha Chemical Co., Ltd.), FA-125 (manufactured by Hitachi Chemical Company, Ltd.), EPTRA and HDDA (manufactured by Daicel Cytec Co., Ltd.), and A-NOD-N (manufactured by SHIN-NAKAMURA CHEMICAL Co., Ltd.).

Photocurable compounds may be used singly or in combinations of two or more of those. When the photocurable compounds is used with an inkjet method, monofunctional and bifunctional (meth)acrylate monomers are preferably used.

The photocurable compound is preferably used in the range of 1% by mass to 80% by mass and, in particular, in the range of 10% by mass to 65% by mass based on the total mass of the curable composition. When the photocurable compound is used in the above range, the hardness of the curable composition can be satisfactory.

Examples of the photocurable compound include (meth)acrylates such as isobornyl (meth)acrylate, tetrahydrofurfuryl (meth)acrylate, glycidyl (meth)acrylate, $\gamma$-butyrolactone (meth)acrylate, and $\gamma$-butyrolactone (meth)acrylate; (meth)acryloyls such as acryloylmorpholine; 2-hydroxy-3-acryloyloxypropyl (meth)acrylate, hydroxypivalyl hydroxypivalate di(meth)acrylate, 1,3-butylene glycol di(meth)acrylate), 2,methyl-1,3-butylene glycol di(meth)acrylate, 1,4-butanediol di(meth)acrylate, 1,6-hexanediol di(meth)acrylate, 1,9-nonanediol di(meth)acrylate, 1,10-decanediol di(meth)acrylate, 3,methyl-1,5-pentanediol di(meth)acrylate, ethoxylated 1,6-hexanediol di(meth)acrylate, neopentyl glycol di(meth)acrylate, propoxylated neopentyl glycol di(meth)acrylate, polyethylene glycol #200 di(meth)acrylate, polyethylene glycol #400 di(meth)acrylate, dipropylene glycol di(meth)acrylate, tripropylene glycol di(meth)acrylate, polypropylene glycol #400 di(meth)acrylate, polypropylene glycol (#700) di(meth)acrylate, 1,10-decanediol di(meth)acrylate, glycerin di(meth)acrylate, ethylene glycol di(meth)acrylate, diethylene glycol di(meth)acrylate, triethylene glycol di(meth)acrylate, polyethylene glycol #600 di(meth)acrylate, polyethylene glycol #1000 di(meth)acrylate, ethoxylated polypropylene glycol #700 di(meth)acrylate, polypropylene glycol #400 di(meth)acrylate; trimethylolpropane triacrylates and alkylene oxide modified products such as ethoxylated trimethylolpropane triacrylate (TMP3EOTA, TMP9EOTA), propoxylated trimethylolpropane triacrylate (TMP3POTA), and propoxylated glyceryl triacrylate (G3POTA, G3.5POTA); trimethylolpropane trimethacrylate and alkylene oxide modified products such as ethoxylated trimethylolpropane trimethacrylate (TMP3EOTMA, TMP9EOTMA); pentaerythritol tri(meth)acrylate; and tetrafunctional photopolymerizable polyfunctional monomers such as pentaerythritol tetra(meth)acrylate and ethoxylated pentaerythritol tetra(meth)acrylate (EO35mol).

[Photothermally reactive compound]

Moreover, in the present invention, a compound having one or more (meth)acryloyl groups within one molecule and a functional group capable of reacting with isocyanate can be used as a photothermally reactive compound. Here, the functional group capable of reacting with isocyanate is a functional group having an active hydrogen atom, and examples include an OH group, an NH group, an NH2 group, an SH group, and a COOH group. The photothermally reactive compound having the above functional group causes a photocurable reaction as well as a thermosetting reaction with a thermosetting compound even when an isocyanate-reactive component is not used further.

Examples of the photothermally reactive compounds include monofunctional alcohols such as 2-hydroxyethyl acrylate, 2-hydroxypropyl acrylate, 4-hydroxybutyl acrylate, 2-hydroxymethyl methacrylate, and pentaerythritol triacrylate; any one of acrylates from ethylene oxide adducts and propylene oxide adducts of polyfunctional alcohols such as trimethylolpropane and hydrogenated bisphenol A or polyphenols such as bisphenol A and biphenol; polyfunctional or monofunctional polyurethane acrylates that are isocyanate modified products of hydroxyl group-containing acrylate, bisphenol A diglycidyl ether, hydrogenated bisphenol A diglycidyl ether, or epoxy acrylates that are (meth)acrylic acid adducts of phenol novolac epoxy resins; and oxetanyl group-containing acrylates such as oxetanyl acrylate and corresponding methacrylate compounds. Acrylic acid can also be used.

Examples of the commercially available products for the above include 4HBA (manufactured by Osaka Organic Chemical Industry Ltd.) and 4HBA (manufactured by Nihon Kasei Co., Ltd.); epoxy acrylates such as UNIDIC V-5500, UNIDIC V-5502, and UNIDIC V-5508 (all manufactured by DIC Corporation); and EA-1010N (manufactured by SHIN-NAKAMURA CHEMICAL Co., Ltd.).

The curable composition of the present invention can contain, in addition to the indispensable component, i.e., photocurable compound (A), either one of or both the above thermosetting compound and the photothermally reactive compound. It is preferable that the curable composition contains all of the photocurable compound (A), the thermosetting compound, and the photothermally reactive compound.

In addition to the above, additives such as antifoaming /leveling agents, thixotropy imparting agents/thickeners, coupling agents, dispersants, flame retardants, rust inhibitor or antioxidants, and fluorescent whitening agents can be contained in the curable composition of the present invention as necessary.

As antifoaming agents/leveling agents, usable are compounds such as silicone, modified silicone, mineral oil, vegetable oil, fatty alcohol, fatty acid, metal soap, fatty acid amide, polyoxyalkylene glycol, polyoxyalkylene alkyl ether, and polyoxyalkylene fatty acid ester.

As thixotropy imparting agents/thickeners, usable are viscous minerals such as kaolinite, smectite, montmorillonite, bentonite, talc, mica, and zeolite, fine particle silica, silica gel, amorphous inorganic particles, polyamide-based additives, modified urea-based additives, and wax-based additives.

By adding an antifoaming /leveling agent and a thixotropy imparting agent/thickener, the surface properties of a cured product and the properties of a composition can be regulated.

As coupling agents, usable are compounds containing a methoxy group, an ethoxy group, acetyl, or the like as the alkoxy group, and vinyl, methacryl, acryl, epoxy, cyclic epoxy, mercapto, amino, diamino, acid anhydride, ureido, sulfide, isocyanate, or the like as the reactive functional group, for example, silane coupling agents such as vinyl-based silane compounds such as vinyl ethoxysilane, vinyl trimethoxysilane, vinyl·tris(β-methoxyethoxy)silane, and γ-methacryloxypropyltrimethoxysilane, amino-based silane compounds such as γ-aminopropyltrimethoxysilane, N-β- (aminoethyl)-γ-aminopropyltrimethoxysilane, N-β- (aminoethyl)-γ-aminopropylmethyldimethoxysilane, and γ-ureidopropyltriethoxysilane, epoxy-based silane compounds such as γ-glycidoxypropyltrimethoxysilane, β-(3,4-epoxycyclohexyl)ethyltrimethoxysilane, and γ-glycidoxypropylmethyldiethoxysilane, mercapto-based silane compounds such as γ-mercaptopropyltrimethoxysilane, and phenylamino-based silane compounds such as N-phenyl-γ-aminopropyltrimethoxysilane; titanate-based coupling agents such as isopropyl triisostearoylated titanate, tetraoctyl bis(ditridecyl phosphite) titanate, bis(dioctyl pyrophosphate) oxyacetate titanate, isopropyl tridodecylbenzenesulfonyl titanate, isopropyl tris(dioctyl pyrophosphate) titanate, tetraisopropyl bis(dioctyl phosphite) titanate, tetra(1,1-diallyloxymethyl-1-butyl) bis(ditridecyl) phosphite titanate, bis(dioctyl pyrophosphate) ethylene titanate, isopropyl trioctanoyl titanate, isopropyl dimethacryl isostearoyl titanate, isopropyl tristearoyl diacrylic titanate, isopropyl tri(dioctyl phosphate) titanate, isopropyl tricumyl phenyl titanate, dicumylphenyloxyacetate titanate, and diisostearoyl ethylene titanate; zirconate-based coupling agents such as ethylenically unsaturated zirconate-containing compounds, neoalkoxy zirconate-containing compounds, neoalkoxy trisneodecanoyl zirconate, neoalkoxy tris(dodecyl)benzenesulfonyl zirconate, neoalkoxy tris(dioctyl)phosphate zirconate, neoalkoxy tris(dioctyl)pyrophosphate zirconate, neoalkoxy tris(ethylenediamino)ethyl zirconate, neoalkoxy tris(m-amino)phenyl zirconate, tetra(2,2-diallyloxymethyl)butyl, di(ditridecyl)phosphite zirconate, neopentyl(diallyl)oxy, trineodecanoyl zirconate, neopentyl(diallyl)oxy, tri(dodecyl)benzene-sulfonyl zirconate, neopentyl(diallyl)oxy, tri(dioctyl)phosphato zirconate, neopentyl(diallyl)oxy, tri(dioctyl)pyro-phosphato zirconate, neopentyl(diallyl)oxy, tri(N-ethylenediamino)ethyl zirconate, neopentyl(diallyl)oxy, tri(m-amino)phenyl zirconate, neopentyl(diallyl)oxy, trimethacryl zirconate, neopentyl(diallyl)oxy, triacryl zirconate, dineopentyl(diallyl)oxy, diparaaminobenzoyl zirconate, dineopentyl(diallyl)oxy, di(3-mercapto)propionic zirconate, zirconium (IV) 2,2-bis(2-propenolatomethyl) butanolato, cyclodi[2,2-(bis2-propenolatomethyl)butanolato]pyrophosphato-O,O; and aluminate-based coupling agents such as diisobutyl(oleyl)acetoacetyl aluminate and alkyl acetoacetate aluminum diisopropylate.

As dispersants, usable are high-molecular dispersants such as polycarboxylic acid-based, naphthalene sulfonic acid formalin condensation-based, polyethylene glycol, polycarboxylic acid partial alkyl ester-based, polyether-based, and polyalkylene polyamine-based dispersants, and low-molecular dispersants such as alkyl sulfonic acid-based, quaternary ammonium-based, higher alcohol alkylene oxide-based, polyhydric alcohol ester-based, and alkyl polyamine-based dispersants. As flame retardants, usable are hydrated metal-based flame retardants such as aluminum hydroxide and magnesium hydroxide, red phosphorus, ammonium phosphate, ammonium carbonate, zinc borate, zinc stannate, molybdenum compound-based, bromine compound-based, chlorine compound-based, phosphoric acid ester, phosphorus-containing polyol, phosphorus-containing amine, melamine cyanurate, melamine compound, triazine compound, guanidine compound, silicone polymer flame retardants, and the like.

As the rust inhibitor or antioxidants, it is possible to use sulfur-based antioxidants, phosphorus-based antioxidants, aromatic amine-based antioxidants, phenol-based antioxidants, and the like.

As the fluorescent whitening agents, it is possible to use benzoxazoyl derivatives, coumarin derivatives, styrenebiphenyl derivatives, pyrazolone derivatives, bis(triazinylamino)stilbenedisulfonic acid derivatives, and the like.

In order to regulate the polymerization rate and the polymerization degree, it is further possible to add a polymerization inhibitor and a polymerization retarder.

The curable composition of the present invention is applicable to printing by an inkjet method. For being applicable to the printing by an inkjet method, the curable composition preferably has a viscosity such that the composition can be jetted by an inkjet printer.

Viscosity refers to viscosity measured according to JIS Z 8803. The viscosity of the curable composition for inkjet is preferably 150 mPa·s or less at room temperature (25°C). As described above, the viscosity of the ink used in the inkjet printer is preferably about 20 mPa·s or less at the temperature at which the coating through inkjet printing is carried out. With the viscosity of 150 mPa·s or less at room temperature, the above conditions can be satisfied even by heating before or at coating (printing). Accordingly, with the curable composition of the present invention, a pattern can be printed directly on a printed wiring board substrate or the like.

Since the curable composition of the present invention contains a photopolymerization initiator, a light of 50 mJ/cm$^2$ to 1000 mJ/cm$^2$ can be irradiated to a layer of the curable composition immediately after being printed to optically cure the layer. Light irradiation is performed by irradiation of active energy rays such as ultraviolet rays, electron beams, and actinic rays, and preferably ultraviolet rays.

For example, as for a composition containing an ultraviolet-sensitive photopolymerization initiator, the composition layer can be photocured by ultraviolet irradiation.

Ultraviolet irradiation in an inkjet printer can be performed by, for example, attaching a light source such as a high-pressure mercury lamp, a metal halide lamp, or an ultraviolet LED to a lateral side of the print head, and performing scanning by moving the print head or a substrate. In this case, printing and ultraviolet irradiation can be performed almost simultaneously.

The curable composition after being photocured is thermally cured by using a known heating means, e.g., a heating oven such as a hot air oven, an electric oven, or an infrared induction heating oven. As for heating conditions, heating at 150°C to 170°C for 5 minutes to 120 minutes is preferable.

As described above, the curable composition is suitable for printing by an inkjet method, and an example of the printing target is, but is not limited to, a printed wiring board.

Accordingly, an electronic component having the cured product of the present invention is a product having excellent reliability and durability due to the excellent physical properties of the cured product.

In the present invention, the electronic component refers to a component for use in an electronic circuit, including in addition to active components such as printed wiring boards, transistors, light emitting diodes, and laser diodes, passive components such as resistors, capacitors, inductors, and connectors. A cured coat film of the curable composition of the present invention provides the effects of the present invention.

Examples

The present invention will now be described in more detail by way of Examples.

[Examples 1 to 12, Comparative Examples 1 to 4]

I. Preparation of compositions

Components were blended in the proportions shown in Table 1 and stirred by a dissolver. Thereafter, the mixtures were dispersed for 2 hours by a bead mill using 1 mm zirconia beads, and thus curable compositions of Examples 1 to 12 and Comparative Examples 1 to 4 were obtained.

II. Property tests

The following property tests were performed on each of the above compositions. The results are shown in Table 1.

<1. Injection property evaluation>

The viscosities of the curable compositions of Examples and Comparative Examples at 25°C at 100 rpm were measured with a cone plate viscometer (TVH-33H manufactured by Toki Sangyo Co., Ltd.). Evaluation results is shown in Table 1, based on the following criteria.

○ 150 mPa·s or less
× More than 150 mPa·s

<2. Reflectance evaluation>

The curable compositions of Examples 1 to 12 and Comparative Examples 1 to 4 were applied to a copper foil using an applicator, exposed to UV light (a high pressure mercury lamp at 500 mJ/cm$^2$), and heat-treated in a convection type drying oven at 150°C for 60 minutes, to obtain cured coat films having a thickness of 20 μm. The reflectance in the vicinity of 450 nm of the obtained cured coat films was measured using a spectrocolorimeter CM-2600d manufactured by KONICA MINOLTA, INC., and the evaluation results based on the following criteria are shown in Table 1.

◎ reflectance of 75% or more
○ reflectance of 70% or more and less than 75%
× reflectance of less than 70%

<3. Discoloration ratio (yellowing) evaluation>

The curable composition samples of Examples and Comparative Examples were applied to a copper foil using an applicator, exposed to UV light (a high pressure mercury lamp at 500 mJ/cm$^2$), and heat-treated in a convection type drying oven at 150°C for 60 minutes, to obtain cured coat films having a thickness of 20 μm. The L*a*b* of the cured coat films immediately after the preparation was measured (measurement of an initial value) using a spectrocolorimeter CM-2600d manufactured by KONICA MINOLTA, INC.

Thereafter, reflow treatment was performed 3 times on each of the above samples for accelerated deterioration, by retaining the samples at a peak temperature of 260°C for 60 seconds in an air atmosphere, using a reflow apparatus (NIS-20 series manufactured by Eightech Tectron Co., Ltd.). The L*a*b* was measured again (measurement of a value after reflow treatment).

ΔE*ab was calculated by the following expression.

$$\Delta E^*ab = (L^*2 - L^*1)2 + (a^*2 - a^*1)2 + (b^*2 - b^*1)2)0.5$$

(In the expression, L*1, a*1, and b*1 represent the initial L*, a*, and b* values, respectively, and L*2, a*2, and b*2 represent the values of L*, a*, and b* after reflow treatment, respectively.)

Accordingly, ΔE*ab is the difference between the initial value and the value after accelerated deterioration in the L*a*b* color system, wherein the greater the value, the greater the color change. The results of evaluation based on the following criteria are shown in Table 1.

○ ΔE*ab being 5 or less
× ΔE*ab exceeding 5

<4. Solder heat resistance evaluation>

The curable compositions of Examples and Comparative Examples were applied to a copper foil using an applicator, exposed to UV light (a high pressure mercury lamp at 500 mJ/cm$^2$), and heat-treated in a convection type drying oven at 150°C for 60 minutes, to obtain cured coat films having a thickness of 20 μm. The cured coat films were subjected to a solder heat resistance test by a solder float method according to the method of JIS C-5012. Each sample was immersed in a solder bath at 260°C for 10 seconds, then removed from the solder bath, spontaneously cooled, washed with propylene glycol monomethyl ether acetate, and dried. This test was repeated 3 times, then the state of the coat films was visually observed, and then a peeling test with cellophane adhesive tape was performed. The evaluation results are shown in Table 1.

The evaluation criteria are as follows.

◎ No change in coat film before and after solder heat resistance test
○ No change through visual observation, but slight peeling observed at the edge of substrate in peeling test
× Coat film completely peeled

<5. Evaluation of crack resistance upon solder reflowing>

The curable compositions of Examples and Comparative Examples were applied to FR-4 (a substrate) using an applicator, exposed to UV light (a high pressure mercury lamp at 500 mJ/cm$^2$), and heat-treated in a convection type drying oven at 150°C for 60 minutes, to obtain cured coat films having a thickness of 20 μm. Then, the temperature inside a reflowing oven was measured 5 times, in advance, by use of NIS-20-82C manufactured by Eightech Tectron Co., Ltd., under the same conditions as the reflow conditions to be performed, with the conveyor speed and heat source setting temperature shown below (see Fig. 1), to confirm that there was no significant deviation. Thereafter, reflow treatment was performed 3 times on the test substrates obtained above, with the above mentioned conditions being maintained. The external appearance was visually inspected, and the results are shown in Table 1. The evaluation criteria are as follows.

○ No change in appearance at all
Δ Cracks of 5 mm or less produced
× Cracks exceeding 5 mm produced

Conveyor speed: Passing at the rate of 1.0 m/min ≈ 1 zone (about 35 cm) in about 20 seconds
Heat source temperature: A. 210°C, B. 190°C, C. to F. 185°C, G. 265°C, H. 285°C, I. to J. Cooling step with a fan

<6. Insulating property evaluation>

Printing with an IJ printer was performed on an IPCB-25 comb-shaped electrode B coupon (a substrate) to give a film thickness of 40 μm. After preliminary UV curing, heat treatment was performed for 60 minutes in a convection type drying oven at 150°C. The obtained substrate was exposed to a voltage of 100 V for 168 hours, in a chamber set at IPC-TM-650 class H test conditions, and then the insulation resistance value was determined. The evaluation criteria are as follows.

○ $5 \times 108$ Ω or more
× Less than $5 \times 108$ Ω

<7. Solubility evaluation>

For each Example and Comparative Example, one of the fluorescent whitening agents to be used was added to a diluent and stirred at a liquid temperature of 40°C for 30 minutes. The undissolved residue was visually observed to evaluate the solubility of the fluorescent whitening agents in the diluent. The results are shown in Table 1. The evaluation criteria are as follows.

◎ 1.0% by mass of the fluorescent whitening agent dissolved, based on the amount of the diluent
○ 0.5% by mass of the fluorescent whitening agent dissolved, based on the amount of the diluent
Δ 0.3% by weight of the fluorescent whitening agent dissolved, based on the amount of the diluent
× Not dissolved at all

<8. Particle evaluation>

Grain marks were observed by use of a grind gauge having a maximum depth of 25 μm, in accordance with JIS K-5101 and K 5600. More precisely, the curable compositions immediately after preparation of each Example and Comparative Example were dripped to the grind gauge from the deepest side of the gauge to such an extent that the composition slightly overflowed the groove. The inks were scraped off with the scraper being swept from one side having a 25 μm-groove depth to the other side having a 0 μm-groove depth, with holding the scraper to have the same speed and the same pressure. The grain mark(s) and streaks drawn on the grind gauge were evaluated. The results are shown in Table 1.
The evaluation criteria are as follows.

◎ No grains or streaks observed
○ Streaks of 1 cm or more formed at a depth of 3 μm or less
Δ Streaks of 1 cm or more formed at a depth of more than 3 μm and 5 μm or less
× Streaks of 1 cm or more produced at a depth of 5 μm or more

[Table 1]

Table 1

| | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|
| (A) | White colorant *1 | 30 | 30 | 30 | 30 | 30 | 30 | 30 | 30 | 30 | 30 | 30 | 30 |
| (B) | Acylphosphine oxide-based initiator *2 | 5 | 5 | 5 | 5 | 5 | 5 | 5 | 5 | 5 | 5 | 5 | 5 |
| | Acylphosphine oxide-based initiator *3 | 2 | 2 | 2 | 2 | 2 | 2 | 2 | 2 | 2 | 2 | 2 | 2 |
| (C) | Bifunctional (meth)acrylate monomer having heterocycle *4 | 9 | 20 | 40 | 60 | 5 | 5 | 5 | 5 | 5 | 5 | 5 | 9 |
| | Bisphenol A difunctional acrylate *5 | 0 | 0 | 0 | 0 | 0 | 0 | 0 | 0 | 0 | 0 | 0 | 0 |
| | Dioxolane acrylate *6 | 0 | 0 | 0 | 0 | 0 | 0 | 0 | 0 | 0 | 0 | 0 | 0 |
| (D) | Block isocyanate *7 | 10 | 10 | 10 | 10 | 10 | 10 | 10 | 10 | 10 | 10 | 10 | 10 |
| (E) | Hyperbranched oligomer *8 | 1 | 1 | 1 | 1 | 5 | 5 | 5 | 5 | 5 | 5 | 5 | 1 |
| | 4-Hydroxybutyl acrylate *9 | 5 | 5 | 5 | 5 | 5 | 5 | 5 | 5 | 5 | 5 | 5 | 5 |
| (F) | Fluorescent whitening agent A*10 | 0.15 | 0.15 | 0.15 | 0.15 | 0.15 | 0.15 | 0.15 | 0.15 | 0 | 0 | 0.15 | 0 |
| | Fluorescent whitening agent B*11 | 0 | 0 | 0 | 0 | 0 | 0 | 0 | 0 | 0.15 | 0.15 | 0 | 0 |

EP 3 778 657 A1

(continued)

| | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|
| (G) | 1,9-Nonanediol diacrylate *12 | 90 | 80 | 60 | 40 | 80 | 0 | 0 | 0 | 80 | 0 | 0 | 90 |
| | 1.6-Hexanediol diacrylate *13 | 0 | 0 | 0 | 0 | 0 | 80 | 0 | 0 | 0 | 80 | 0 | 0 |
| | Dipropylene glycol diacrylate *14 | 0 | 0 | 0 | 0 | 0 | 0 | 0 | 0 | 0 | 0 | 80 | 0 |
| | Butyl acrylate *15 | 0 | 0 | 0 | 0 | 0 | 0 | 80 | 0 | 0 | 0 | 0 | 0 |
| | Propylene glycol monomethyl ether acetate *16 | 0 | 0 | 0 | 0 | 0 | 0 | 0 | 80 | 0 | 0 | 0 | 0 |
| | Methacryloyl group-containing bisphenol A epoxy resin *17 | 0 | 0 | 0 | 0 | 5 | 5 | 5 | 5 | 5 | 5 | 5 | 0 |
| A | Melamine | 1 | 1 | 1 | 1 | 1 | 1 | 1 | 1 | 1 | 1 | 1 | 1 |
| | Rust inhibitor *18 | 1 | 1 | 1 | 1 | 1 | 1 | 1 | 1 | 1 | 1 | 1 | 1 |
| | Σ | 154.15 | 155.15 | 155.15 | 155.15 | 149.15 | 149.15 | 149.15 | 149.15 | 149.15 | 149.15 | 149.15 | 154 |

(continued)

| | | Example 1 | Example 2 | Example 3 | Example 4 | Example 5 | Example 6 | Example 7 | Example 8 | Example 9 | Example 10 | Example 11 | Example 12 |
|---|---|---|---|---|---|---|---|---|---|---|---|---|---|
| Evaluation | Injection property | ○ | ○ | ○ | ○ | ○ | ○ | ○ | ○ | ○ | ○ | ○ | ○ |
| | Crack resistance upon solder reflowing | ○ | ○ | ○ | ○ | ○ | ○ | ○ | ○ | ○ | ○ | ○ | ○ |
| | Solder heat resistance | ◎ | ◎ | ◎ | ◎ | ◎ | ◎ | ◎ | ◎ | ◎ | ○ | ○ | ◎ |
| | Reflectance | ◎ | ◎ | ◎ | ◎ | ◎ | ◎ | ◎ | ◎ | ◎ | ◎ | ◎ | ○ |
| | Discoloration ratio | ○ | ○ | ○ | ○ | ○ | ○ | ○ | ○ | ○ | ○ | ○ | ○ |
| | Solubility | ○ | ○ | ○ | ○ | ◎ | ◎ | ◎ | ◎ | ◎ | ◎ | ○ | ○ |
| | Particle | ○ | ○ | ○ | ○ | ◎ | ◎ | ◎ | ◎ | ○ | ○ | ○ | ○ |
| | Insulation properties | ○ | ○ | ○ | ○ | ○ | ○ | ○ | ○ | ○ | ○ | ○ | ○ |

[Table 2]

Table 1 (continued)

| | | | Comparative Example 1 | Comparative Example 2 | Comparative Example 3 | Comparative Example 4 |
|---|---|---|---|---|---|---|
| (A) | White colorant *1 | | 30 | 30 | 30 | 30 |
| (B) | Acylphosphine oxide-based initiator *2 | | 5 | 5 | 5 | 5 |
| | Acylphosphine oxide-based initiator *3 | | 2 | 2 | 2 | 2 |
| (C) | Bifunctional (meth)acrylate monomer having heterocycle *4 | | 0 | 0 | 0 | 9 |
| | Bisphenol A difunctional acrylate*5 | | 0 | 9 | 0 | 0 |
| | Dioxolane acrylate *6 | | 0 | 0 | 9 | 0 |
| (D) | Block isocyanate *7 | | 10 | 10 | 10 | 0 |
| (E) | Hyperbranched oligomer *8 | | 1 | 1 | 1 | 1 |
| | 4-Hydroxybutyl acrylate *9 | | 5 | 5 | 5 | 5 |
| (F) | Fluorescent whitening agent A *10 | | 0.15 | 0.15 | 0.15 | 0.15 |
| | Fluorescent whitening agent B *11 | | 0 | 0 | 0 | 0 |
| (G) | 1,9-Nonanediol diacrylate *12 | | 100 | 90 | 90 | 100 |
| | 1.6-Hexanediol diacrylate *13 | | 0 | 0 | 0 | 0 |
| | Dipropylene glycol diacrylate *14 | | 0 | 0 | 0 | 0 |
| | Butyl acrylate *15 | | 0 | 0 | 0 | 0 |
| | Propylene glycol monomethyl ether acetate *16 | | 0 | 0 | 0 | 0 |
| | Methacryloyl group-containing bisphenol A epoxy resin *17 | | 0 | 0 | 0 | 0 |
| | Melamine | | 1 | 1 | 1 | 1 |
| | Rust inhibitor *18 | | 1 | 1 | 1 | 1 |
| | $\Sigma$ | | 155.15 | 154.15 | 155.15 | 154.15 |

(continued)

| | | Comparative Example 1 | Comparative Example 2 | Comparative Example 3 | Comparative Example 4 |
|---|---|---|---|---|---|
| Evaluation | Injection property | ○ | ○ | ○ | ○ |
| | Crack resistance upon solder reflowing | × | Δ | × | × |
| | Solder heat resistance | × | ○ | × | × |
| | Reflectance | ◎ | ◎ | ◎ | ◎ |
| | Discoloration ratio | × | × | × | ○ |
| | Solubility | ○ | ○ | ○ | ○ |
| | Particle | ○ | ○ | ○ | ○ |
| | Insulation properties | ○ | ○ | ○ | ○ |

The details of the materials listed in Table 1 are as follows.

*1 Rutile type titanium oxide

*2 Omnirad TPO, manufactured by IGM Resins

*3 Omnirad 819, manufactured by IGM Resins

*4 KAYARAD R-604, manufactured by Nippon Kayaku Co., Ltd.

*5 BPE-4, manufactured by SHIN-NAKAMURA CHEMICAL Co., Ltd.

*6 MEDOL-10, manufactured by Osaka Organic Chemical Industry Ltd.

*7 BI 7982, manufactured by Baxenden Chemicals Ltd.

*8 Viscoat #1000, manufactured by Osaka Organic Chemical Industry Ltd.

*9 4HBA, manufactured by Nihon Kasei Co., Ltd.

*10 PA-100, manufactured by Showa Chemical Industry Co., Ltd.

*11 Tinopal OB CO, manufactured by BASF Japan Ltd., benzoxazole-based fluorescent whitening agent

*12 A-NOD-N, manufactured by SHIN-NAKAMURA CHEMICAL Co., Ltd.

*13 HDDA, manufactured by Osaka Organic Chemical Industry Ltd.

*14 DPGDA, manufactured by DAICEL-ALLNEX LTD.

*15 BA, manufactured by Tokyo Chemical Industry Co., Ltd.

*16 PMA, manufactured by BASF Japan Ltd.

*17 EA-1010N, manufactured by SHIN-NAKAMURA CHEMICAL Co., Ltd.

*18 IRGANOX 1010, manufactured by BASF Japan Ltd.

[Evaluation]

It was exhibited that the composition of the present invention is excellent in all of the injection property, crack resistance upon solder reflowing, solder heat resistance, reflectance, and discoloration ratio. It is considered that the composition of the present invention is extremely suitable to the application as a white solder resist that requires these properties.

On the other hand, cracked were observed upon solder reflowing, in the composition containing bisphenol A type difunctional acrylate (Comparative Example 2) in place of the di- or higher functional (meth)acrylate monomer having a heterocycle (C) for use in the present invention, and in the composition containing monofunctional acrylate having a heterocyclic group (Comparative Example 3). Satisfactory evaluations were not attained, either, with respect to both reflectivity and discoloration, in the comparative examples.

The present invention is not limited to the structures of the above embodiments and the Examples, and various modifications can be made within the scope of the invention.

Claims

1.  A curable composition comprising:

(A) a white colorant;
(B) a photopolymerization initiator;
(C) a di- or higher functional (meth)acrylate monomer having a heterocycle; and
(D) a thermosetting compound.

2. The curable composition according to claim 1, wherein (C) the di- or higher functional (meth)acrylate monomer having a heterocycle is a 5- or 6-membered alicyclic heterocycle compound having 1 or 2 heteroatoms.

3. The curable composition according to claim 1 or 2, further comprising (E) a hyperbranched polymer or oligomer having an ethylenically unsaturated group.

4. The curable composition according to any one of claims 1 to 3,
wherein (A) the white colorant has an average particle diameter of 1 $\mu$m or less.

5. The curable composition according to any one of claims 1 to 4, further comprising (F) a fluorescent whitening agent and (G) a diluent for dissolving the fluorescent whitening agent.

6. The curable composition according to any one of claims 1 to 5 for use in inkjet printing.

7. A cured product of the curable composition according to any one of claims 1 to 6.

8. An electronic component comprising the cured product according to claim 7.

[Fig. 1]

## INTERNATIONAL SEARCH REPORT

| International application No. |
| --- |
| PCT/JP2019/012874 |

**A. CLASSIFICATION OF SUBJECT MATTER**

Int.Cl. C08F2/44(2006.01)i, B41M5/00(2006.01)i, C08F2/48(2006.01)i, C08K3/013(2018.01)i, C08L101/00(2006.01)i, C09D11/322(2014.01)i, H05K3/28(2006.01)i

According to International Patent Classification (IPC) or to both national classification and IPC

**B. FIELDS SEARCHED**

Minimum documentation searched (classification system followed by classification symbols)

Int.Cl. C08F2/44-2/50, B41M5/00, C08K3/00-13/08, C08L1/00-101/16, C09D11/322, H05K3/28

Documentation searched other than minimum documentation to the extent that such documents are included in the fields searched

| | |
| --- | --- |
| Published examined utility model applications of Japan | 1922–1996 |
| Published unexamined utility model applications of Japan | 1971–2019 |
| Registered utility model specifications of Japan | 1996–2019 |
| Published registered utility model applications of Japan | 1994–2019 |

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2012-214534 A (TAIYO HOLDINGS CO., LTD.) 08 November 2012, claims, paragraphs [0023], [0032], example 4 & WO 2012/132423 A1 & CN 103403106 A | 1, 4, 6-8 |
| Y | | 5 |
| Y | WO 2016/157587 A1 (TAIYO INK MFG. CO., LTD.) 06 October 2016, claims, paragraphs [0054]-[0056], examples & CN 107406681 A | 5 |

☒ Further documents are listed in the continuation of Box C. ☐ See patent family annex.

| | |
| --- | --- |
| * Special categories of cited documents: | "T" later document published after the international filing date or priority date and not in conflict with the application but cited to understand the principle or theory underlying the invention |
| "A" document defining the general state of the art which is not considered to be of particular relevance | |
| "E" earlier application or patent but published on or after the international filing date | "X" document of particular relevance; the claimed invention cannot be considered novel or cannot be considered to involve an inventive step when the document is taken alone |
| "L" document which may throw doubts on priority claim(s) or which is cited to establish the publication date of another citation or other special reason (as specified) | "Y" document of particular relevance; the claimed invention cannot be considered to involve an inventive step when the document is combined with one or more other such documents, such combination being obvious to a person skilled in the art |
| "O" document referring to an oral disclosure, use, exhibition or other means | |
| "P" document published prior to the international filing date but later than the priority date claimed | "&" document member of the same patent family |

| Date of the actual completion of the international search | Date of mailing of the international search report |
| --- | --- |
| 21 June 2019 (21.06.2019) | 02 July 2019 (02.07.2019) |

| Name and mailing address of the ISA/ Japan Patent Office 3-4-3, Kasumigaseki, Chiyoda-ku, Tokyo 100-8915, Japan | Authorized officer Telephone No. |
| --- | --- |

Form PCT/ISA/210 (second sheet) (January 2015)

**INTERNATIONAL SEARCH REPORT**

International application No.

PCT/JP2019/012874

C (Continuation).   DOCUMENTS CONSIDERED TO BE RELEVANT

| Category* | Citation of document, with indication, where appropriate, of the relevant passages | Relevant to claim No. |
|---|---|---|
| X | JP 4-88030 A (SEKISUI CHEMICAL CO., LTD.) 19 March 1992, claims, examples 4, 14 (Family: none) | 1-2, 4, 7 |
| X | JP 2002-226529 A (NIPPON KAYAKU CO., LTD.) 14 August 2002, claims, paragraph [0034], examples 1, 2 (Family: none) | 1-4, 6-8 |
| A | JP 2009-149878 A (TAIYO INK MFG. CO., LTD.) 09 July 2009, claims, examples & US 2009/0141504 A1, claims, examples & CN 101445644 A | 1-8 |

Form PCT/ISA/210 (continuation of second sheet) (January 2015)

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2016035042 A
- WO 2016157587 A
- JP S5666089 A
- JP S56157089 A
- JP 5968291 B
- JP 5667080 B